# EUROPÄISCHE PATENTSCHRIFT

(11) **EP 2 463 892 B1**
(45) Veröffentlichungstag und Bekanntmachung des Hinweises auf die Patenterteilung: **03.04.2013**
(21) Anmeldenummer: 10015569.6
(22) Anmeldetag: 13.12.2010
(51) Int. Cl.: H01L 21/67, H01L 21/68

(54) **Einrichtung, Vorrichtung und Verfahren zur Ermittlung von Ausrichtungsfehlern**
Device, assembly and method for detecting alignment errors
Installation, dispositif et procédé de détection de défauts d'alignement

(43) Veröffentlichungstag der Anmeldung: 13.06.2012
(73) Patentinhaber: EV Group E. Thallner GmbH, 4782 St. Florian am Inn (AT)
(72) Erfinder: Wimplinger Markus, 4910 Ried im Innkreis (AT)
(74) Vertreter: Schweiger, Johannes

(56) Entgegenhaltungen:
- EP-A1- 1 705 705
- WO-A1-2009/133682
- US-A1- 2005 255 666
- US-A1- 2007 252 994

## Beschreibung

Die Erfindung betrifft eine Einrichtung zur Ermittlung von durch Dehnung und/oder Verzerrung eines ersten Substrats gegenüber einem zweiten Substrat beim Verbinden des ersten Substrats mit dem zweiten Substrat aufgetretenen lokalen Ausrichtungsfehlerngemäß Patentanspruch 1. Außerdem betrifft die Erfindung eine Vorrichtung zum Erfassen und / oder Vorhersagen von Verzerrungen, insbesondere die Ausrichtung von Substraten beeinflussende Verzerrungen, von Substraten sowie einer Vorrichtung zum Ausrichten und / oder dem Inspizieren der Ausrichtung einer ersten Kontaktfläche eines ersten Substrats mit einer zweiten Kontaktfläche eines zweiten Substrats gemäß Anspruch 4 und ein Verfahren gemäß Anspruch 8. Weiters betrifft die Erfindung eine Verwendung gemäß Anspruch 13.

Die WO 20091133682 A1 zeigt ein Verfahren zur Beurteilung des Grades der Verformung in der Ebene eines Substrats in einer Lameniervorrichtung. Das Verfahren umfasst: einen Vor-Messschritt, bei dem die Relativposition des ersten Substrats und des zweiten Substrats gemessen wird, bevor diese übereinander angeordnet werden; ein Nach-Messschritt, bei dem die Relativposition des ersten Substrats und des zweiten Substrats nach Übereinanderanordnung des ersten Substrats und des zweiten Substrats gemessen wird; und ein Auswertungsschritt, bei dem auf Grund der Relativpositionen des Vor-Messschrittes und der Relativposition des Nach-Messschrittes ausgewertet wird.

In der früheren europäischen Patentanmeldung 09012023.9 werden die bei der Ausrichtung bestehenden grundlegenden Probleme auf den Seiten 1 bis 3 beschrieben.

Durch die immer wichtiger werdende 3D Technologie in Kombination mit der weiter fortschreitenden Miniaturisierung wird es bei Bondprozessen zunehmend bedeutender, einen korrekten Ausrichtungsprozess (alignment), insbesondere gekoppelt mit einem sogenannten pre-bonding Schritt, welcher die Wafer mittels einer trennbaren Verbindung miteinander verbindet, vor dem eigentlichen Bondvorgang durchzuführen. Dies gewinnt vor allem bei Anwendungen, in denen Ausrichtungsgenauigkeiten von besser 2µm für alle, am Wafer befindlichen Stellen angestrebt werden, an Bedeutung. Die Wichtigkeit und die Anforderungen an die Genauigkeit der Ausrichtungstechnologie, sowie der Pre-Bonding Prozesse nimmt für angestrebte Genauigkeiten unter 1µm, insbesondere unter 0,5µm oder unter 0,25µm nochmals erheblich zu.

Auf Grund der Tatsache, dass die Strukturen immer kleiner, aber die Wafer gleichzeitig immer größer werden, können sehr gut zueinander ausgerichtete Strukturen in der Nähe von Ausrichtungsmarken vorhanden sein, während an anderen Positionen des Wafers die Strukturen nicht korrekt oder zumindest nicht optimal miteinander verbunden wurden. Um die Strukturen an beiden Seiten der Wafer optimal miteinander zu verbinden, werden sehr aufwendige Ausrichtungstechnologien gekoppelt mit sehr gut kontrollierten und optimierten Bonding Technologien, insbesondere Pre-Bonding Technologien entwickelt.

Die heutige Technologie zielt darauf ab, einige Ausrichtungsmarken an je einer Seite beider Wafer aufzunehmen und die beiden Wafer danach anhand dieser Ausrichtungsmarken auszurichten und zu Bonden. Dabei treten mehrere Probleme auf, abhängig von der jeweiligen Technologie, die zum Ausrichten verwendet wird.

Die Anmelderin hat mit der europäischen Patentanmeldung EP 09012023.9 bereits eine Methode angemeldet, mit deren Hilfe es möglich ist, die gesamte Oberfläche eines Wafers zu vermessen, um eine Aussage über die Positionen der Strukturen an der Oberfläche eines jeden Wafers zu erhalten.

Es ist die Aufgabe der vorliegenden Erfindung, eine gattungsgemäße Vorrichtung beziehungsweise ein gattungsgemäßes Verfahren derart weiterzubilden, dass eine höhere, insbesondere die gesamte Fläche des Wafers betreffende Erfassung zur genaueren Ausrichtung erreicht wird und Fehler bei der Erfassung der Positionen oder der späteren Ausrichtung minimiert werden. Daneben liegt der vorliegenden Erfindung die Aufgabe zugrunde, den Durchsatz bei der Erfassung der Positionen sowie der Ausrichtung von Wafern zu erhöhen.

Diese Aufgabe wird mit den Merkmalen der Ansprüche 1, 4 und 8 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Der Erfindung liegt dabei die Idee zu Grunde, Positionskarten, Dehnungskarten und/oder Spannungskarten der Substrate, insbesondere Wafer, vor, während und/oder nach der Ausrichtung der Substrate aufzunehmen, insbesondere durch mindestens einen transparenten Bereich mindestens eines der Substrate hindurch zu beobachten, und gegebenenfalls die relative Position der beiden Substrate zueinander, insbesondere in-situ, zu korrigieren.

Mit Karten sind Eigenschaften, insbesondere Werte, an bestimmten X-Y-Positionen der Substrate entlang einer Oberfläche gemeint.

Grundidee ist es dabei, zumindest eine Dehnungskarte von Dehnungswerten entlang mindestens eines der Substrate nach dem Verbinden der Substrate zu ermitteln, wobei mit den ermittelten Dehnungswerten lokale Ausrichtungsfehler bestimmt werden können. Lokale Ausrichtungsfehler beziehen sich dabei vorzugsweise auf lokale Strukturen oder Gruppen von lokalen Strukturen der Substrate.

Dabei wird erfindungsgemäß eine Verschiebungskarte des Substrats oder beider Substrate für die durch das Verbinden der Substrate verursachten Verschiebungen erstellt. Die Verschiebungen werden insbesondere durch Verzerrungen und/oder Dehnungen der Substrate verursacht.

Der Grundgedanke besteht darin, abschätzen zu können, wie schwerwiegend (→ Verzerrungsvektoren) die durch den Pre-Bonding Schritt beziehungsweise Verbindungsschritt eingebrachte Verzerrung ist, und zwar an einer Vielzahl von lokalen Positionen auf dem jeweiligen Substrat, vorzugsweise an durch eine Positionskarte des jeweiligen Substrats vorgegebenen Positionen. Man kann zwar die tatsächlich erreichte Ausrichtungsgenauigkeit nach dem Pre-Bonden anhand der transparenten Fenster vermessen, diese sagt aber, wie weiter unten beschrieben, nur wenig über die tatsächlich erreichte Genauigkeit am gesamten Wafer aus, da eben diese Verzerrungen das Ergebnis verschlechtern können. Da die Wafer nicht für Infrarotstrahlung transparent sind, kann die Ausrichtungsgenauigkeit nicht direkt gemessen werden. Erfindungsgemäß wird diese nun mittels der Erfassung der Spannungskarten und/oder Dehnungskarten abgeschätzt.

Ein wesentlicher Aspekt ist, dass die erfindungsgemäße Einrichtung (oder Messgerät) in einer bevorzugten Ausführungsform separat vom Ausrichtungsgerät als eigenes Modul vorgesehen ist.

In einer bevorzugten Ausführungsform ist die Modulaufteilung wie folgt:
1) Modul für Erfassung einer Spannungs- und/oder Dehnungskarte vor dem Verbinden (Bonden oder Pre-Bonden)
2) Ausrichtungsmodul, insbesondere entsprechend der europäischen Patentanmeldung EP 09012023.9. Es könnte aber auch anhand von nur zwei Ausrichtungsmarken die Ausrichtung der Wafer erfolgen. In diesem Fall würden die Positionskarten nicht durch reale Messung erfasst werden, sondern aufgrund des Waferlayouts bekannt sein.
3) mindestens ein Messmodul für die Erfassung der Spannungskarten nach dem Bonden.

Abgesehen von diesem Anwendungsfall ist erfindungsgemäß eine weitere, ebenfalls in der Offenbarung weiter unten beschriebene Ausführungsform denkbar, bei der einer der beiden Wafer weitgehend unstrukturiert ist, d.h. maximal Alignment Marken hat). In diesem Fall geht es darum, Verzerrungen des strukturierten Wafers abschätzen zu können. Bei dieser Ausführungsform ist keine "gemessene" Positionskarte vorgesehen, sondern nur Informationen beziehungsweise Daten über bereits existierende Verzerrungen der Belichtungsfelder und Information, wo sich diese Belichtungsfelder am Wafer befinden. Diese Daten werden "eingelesen" und würden zum einen aus dem Waferlayout bekannt sein (Positionen). Die bereits vorher existierenden Verzerrungen werden mit einem dafür geeigneten Messgerät (in der Regel wird hierfür das Lithographiesystem verwendet) gemessen.

Bei dieser Ausführungsform ist weniger Augenmerk auf das Alignment (exakte Ausrichtung) zu legen (einer der Wafer ist ja weitgehend unstrukturiert), sondern es sind nur die Verzerrungen des strukturierten Wafers relevant. Das Alignment zwischen den beiden Wafern ist hier entweder nur grob (mechanisch - Kante zu Kante) oder optisch (mittels der am weitgehend unstrukturierten Wafer aufgebrachten Ausrichtungsmarken). Die Anforderungen an das optische Alignment sind hier aber in der Regel eher gering.

Die Aufnahme/Erfassung der Positionskarten erfolgt in vorteilhafter Ausführung wie bei der früheren Anmeldung EP09012023.9, die hier nochmals beschrieben wird.

Diese beschreibt ein Verfahren, bei welchen die X-Y-Positionen von Ausrichtungsschlüsseln zweier auszurichtender Substrate in mindestens einem, von einer Bewegung der Substrate unabhängigen X-Y-Koordinatensystem erfassbar beziehungsweise messbar sind, sodass die Ausrichtungsschlüssel eines ersten Substrats durch Korrelation der zugehörigen Ausrichtungsschlüssel eines zweiten Substrats in entsprechende Ausrichtungspositionen ausgerichtet werden können. Damit wird eine Positionskarte jedes auszurichtenden Substrats erstellt.

Mit anderen Worten: Die Vorrichtung stellt Mittel zur Erfassung der Bewegung der Substrate, insbesondere ausschließlich in einer X- und Y-Richtung, zur Verfügung, die auf mindestens einen festen, insbesondere ortsfesten, Bezugspunkt bezogen sind und damit zumindest in einer X- und Y-Richtung eine exakte Ausrichtung der korrespondierenden Ausrichtungsschlüssel ermöglichen.

Die Positionskarte kann mit folgenden Schritten aufgenommen werden:
- Anordnung der ersten Kontaktfläche in einer ersten X-Y-Ebene und der zweiten Kontaktfläche in einer zweiten, zur ersten X-Y-Ebene parallelen X-Y-Ebene,
- Erfassung von X-Y-Positionen von entlang der ersten Kontaktfläche angeordneten ersten Ausrichtungsschlüsseln in einem ersten, von einer Bewegung des ersten Substrats unabhängigen X-Y-Koordinatensystem durch erste Erfassungsmittel und Erfassung von X-Y-Positionen von entlang der zweiten Kontaktfläche angeordneten zweiten, zu den ersten Ausrichtungsschlüsseln korrespondierenden Ausrichtungsschlüsseln in einem zweiten, von einer Bewegung des zweiten Substrats unabhängigen X-Y-Koordinatensystem durch zweite Erfassungsmittel,
- Ausrichtung der ersten Kontaktfläche in einer auf Grundlage der ersten X-Y-Positionen ermittelten ersten Ausrichtungsposition und Ausrichtung der zweiten Kontaktfläche in einer gegenüberliegend zu der ersten Kontaktfläche liegenden, auf Grundlage der zweiten X-Y-Positionen ermittelten zweiten Ausrichtungsposition,

Dies gilt insbesondere auch für die Aufnahme und Bewegung der Wafer auf den Plattformen sowie die Koordinatensysteme und deren Relation zueinander, die auch für die Aufnahme/Erfassung der Dehnungskarten und/oder Spannungskartenverwendet werden können, soweit hier nichts Gegenteiliges beschrieben ist.

Durch die Kombination der Positionskarten, Dehnungs- und/oder Spannungskarten, insbesondere in Verbindung mit den transparenten Bereichen, ist es möglich, eine nach beziehungsweise durch den Kontakt der Wafer, insbesondere nach oder bei dem Pre-Bonding Schritt auftretende fehlerhafte Ausrichtung zu erkennen und die Wafer wieder voneinander zu trennen oder aus dem Herstellungsprozess auszugliedern.

Ein Problem besteht darin, dass mit den bestehenden Technologien üblicherweise nur eine sehr stark begrenzte Anzahl von Ausrichtungsmarken erfasst wird. Üblicherweise wird die Ausrichtung lediglich anhand 2 Ausrichtungsmarken durchgeführt. Dies kann dann den oben beschriebenen negativen Effekt zur Folge haben, dass zwar die Ausrichtung an den Stellen der Ausrichtungsmarken, und in den Ausrichtungsmarken unmittelbar benachbarten Regionen gut sein kann, während die Ausrichtung in den restlichen Bereichen der Wafer unzureichend sein kann.

Ein weiteres Problem besteht darin, dass abhängig vom gewählten Bondverfahren sowohl beim Pre-Bonden der Wafer als auch beim finalen Verbonden der Wafer mechanische Verzerrungen an einem oder beiden Wafern auftreten können, die entweder lokal oder sogar global zu einer Verschlechterung der Ausrichtungsgenauigkeit führen können. Die Bedeutung / der Einfluss dieser Verzerrungen hinsichtlich einer erfolgreichen Ausrichtung der Wafer steigt mit der geforderten Ausrichtungspräzision insbesondere für geforderte Genauigkeiten besser als 2µm. Für Ausrichtungsgenauigkeiten >2µm sind derartige Verzerrungen klein genug, um keinen signifikanten Einfluss auf das Ausrichtungsergebnis darzustellen.

Diese Verzerrungen stellen nicht nur beim Bonden von zwei strukturierten Substraten ein Problem dar, sondern können auch beim Bonden eines strukturierten Substrates auf ein weitgehend unstrukturiertes Substrat zu erheblichen Problemen führen. Dies ist insbesondere dann der Fall, wenn nach dem Bonden weitere Prozessschritte, die eine sehr genaue Ausrichtung zum strukturierten Substrat benötigen, durchgeführt werden sollen. Insbesondere Lithographieschritte, bei denen zusätzliche Lagen von Strukturen zu bereits am Substrat bestehenden Strukturen ausgerichtet werden sollen, stellen hier hohe Anforderungen. Diese Anforderungen steigen mit sinkender Strukturgröße der zu produzierenden Strukturen. Ein derartiger Anwendungsfall tritt beispielsweise in der Fertigung von sogenannten rückseitig belichteten CMOS Bildsensoren (englisch: "Backside Illuminated CMOS Image Sensor") auf. Dabei wird ein erster Wafer mit der bereits strukturierten Oberfläche auf einen, insbesondere weitgehend unstrukturierten, Trägerwafer gebondet. Nach dem Formen einer permanenten Bondverbindung wird der Großteil des Wafermaterials des strukturierten Wafers entfernt, so dass die strukturierte Oberfläche, insbesondere die lichtempfindlichen Stellen von hinten zugänglich werden. Im Anschluss daran muss diese Oberfläche weiteren Prozessschritten, insbesondere Lithographie, unterzogen werden, um beispielsweise die für die Funktion des Bildsensors notwendigen Farbfilter aufzubringen. Verzerrungen dieser Strukturen beinträchtigen die, bei diesem Lithographieschritt erreichbaren Ausrichtungsgenauigkeiten. Für heutige Generationen von Bildsensoren mit einer Pixelgröße von beispielsweise 1,75µm oder 1,1µm liegen die, für ein Belichtungsfeld (bis zu 26 x 32mm) eines Step & Repeat Belichtungssystems zulässigen Verzerrungen bei in etwa 100nm, noch besser bei 70 oder 50nm.

Mit Pre-Bonding werden in diesem Dokument Bonding Verbindungen bezeichnet, die nach dem erfolgten Pre-Bonding Schritt noch eine Trennung der Substrate, insbesondere der Wafer ohne irreparable Beschädigung der Oberflächen zulassen. Daher können diese Bondverbindungen auch als reversibler Bond bezeichnet werden. Diese Trennung ist üblicherweise aufgrund der Tatsache, dass die Bondstärke/Adhäsion zwischen den Oberflächen noch ausreichend niedrig ist, möglich. Diese Trennung ist üblicherweise solange möglich, bis die Bondverbindung dauerhaft, d.h. nicht mehr trennbar (nicht-reversibel) wird. Dies ist insbesondere durch Verstreichen einer bestimmten Zeitspanne und/oder Einwirkung auf die Wafer von außen mittels physikalischer Parameter und/oder Energie erreichbar. Es eignen sich hier insbesondere das Zusammendrücken der Wafer mittels einer Druckkraft oder das Aufheizen der Wafer auf eine bestimmte Temperatur oder die Wafer einer Mikrowellenbestrahlung auszusetzen. Ein Beispiel für eine derartige Pre-Bond-Verbindung wäre eine Verbindung zwischen einer Waferoberfläche mit thermisch erzeugtem Oxid und einer Waferoberfläche mit nativen Oxid, wobei es hier bei Raumtemperatur zu van-der-Waals Verbindungen zwischen den Oberflächen kommt. Derartige Bondverbindungen können durch Temperaturbehandlung in permanente Bondverbindungen umgewandelt werden. Mit Vorteil erlauben derartige Pre-Bonding Verbindungen auch eine Inspektion des Bonding Ergebnisses vor dem Formen der permanenten Bondverbindung. Im Falle von bei dieser Inspektion festgestellten Unzulänglichkeiten können die Substrate noch einmal getrennt und neu zusammengefügt werden.

In der einfachsten Ausführungsform handelt es sich bei der Erfindung um ein Messgerät und Messverfahren, welche die Erfassung der, durch den Pre-Bonding Schritt eingebrachten Spannungen in einem Wafer oder einem Waferpaar ermöglichen. Dies geschieht mittels Analyse der Spannungskarten vor und nach dem Bonden. Hieraus wird eine Spannungsdifferenzkarte nach der nachfolgenden Beschreibung erzeugt.

Diese Spannungsdifferenzkarte ermöglicht eine, insbesondere empirische, Abschätzung der durch den Pre-Bonding Schritt eingebrachten Verzerrung/Dehnung. Hieraus wird ein Verzerrungsvektorfeld oder eine Verzerrungskarte/Dehnungskarte erzeugt.

Dieses Verzerrungsvektorfeld ermöglicht es erfindungsgemäß nun, für Waferpaare, bei denen nur einer der beiden Wafer strukturiert ist, zu ermitteln, welche Verzerrungen an gewissen Positionen, insbesondere an den Ecken des Belichtungsfeldes, bevorzugt an den Positionen der Ausrichtungsmarken für das Lithographiegerät, zusätzlich zu bereits vor dem Bonden existierenden Abweichungen von der Idealform erzeugt wurden.

Das Verzerrungsvektorfeld ermöglicht es alternativ für Waferpaare mit zwei strukturierten Wafern, vorherzusagen, welche zusätzlichen Ausrichtungsabweichungen an den in den Positionskarten erfassten Punkten zusätzlich zu den bereits theoretisch erwarteten (aufgrund der gewählten idealen Ausrichtungspositionen basierend auf den Positionskarten beider Wafer) Abweichungsvektoren zu erwarten sind. Hieraus wird ein Abweichungsvektorfeld beziehungsweise eine Verschiebungskarte erzeugt.

Dieses zu erwartende Abweichungsvektorfeld wird in einer bevorzugten Ausführungsform mit den Abweichungen, die aufgrund der Messungen in den transparenten Fenstern ermittelt wurden, überlagert beziehungsweise addiert. Dies resultiert dann in dem endgültig zu erwartenden Ausrichtungsergebnis für alle entsprechend vorgesehenen Positionen der Positionskarte. Mit diesem Ergebnis kann eine Entscheidung getroffen werden, ob die verbundenen Wafer wieder getrennt werden sollen.

Der Erfindung liegt weiterhin der Gedanke zugrunde, eine Vorrichtung und ein Verfahren anzugeben, bei welchen
- jene Ausrichtungsposition der beiden Wafer zueinander bestimmbar ist, mit der die Menge aller Strukturen auf den Kontaktflächen der Wafer zueinander wirtschaftlich und/oder technisch optimal zueinander stehen. Diese Relativposition kann, muss aber nicht notwendigerweise mit einer perfekten Ausrichtung der Ausrichtungsmarken zueinander korrelieren. Natürlich werden sich die Ausrichtungsmarken immer beinahe in der optimalen Position befinden, d.h. zumindest auf den µm Bereich bezogen sich in unmittelbarer Nähe befinden, aber eben nicht notwendigerweise perfekt und
- bei bereits durchgeführtem "Prebond"-Prozess, also in einem Zustand wo es noch möglich ist, die beiden Wafer voneinander zu trennen, überprüft werden kann, ob die, beim Pre-Bonding Schritt erzeugten Spannungen und die sich daraus mit Wahrscheinlichkeit ableitenden Verzerrungen, insbesondere mechanischen Verzerrungen in einer akzeptablen Größenordnung liegen. Dies findet insbesondere Anwendung in Anwendungsfällen, wo nur einer der beiden Wafer strukturiert ist und der zweite Wafer weitgehend unstrukturiert ist.
- bei bereits durchgeführtem "Prebond"-Prozess, also in einem Zustand wo es noch möglich ist, die beiden Wafer voneinander zu trennen, überprüft werden kann, ob die Genauigkeit der Positionierung der beiden Wafer beziehungsweise der einzelnen Strukturen der Wafer zueinander auch tatsächlich den Vorgaben entspricht. Hierdurch sind bei der gegenseitigen Annäherung der Wafer in Richtung der z-Achse auftretende Verschiebungen, oder noch schlimmer, während des Kontaktprozesses auftretende Abweichungen von der idealen Position, ermittelbar. Insbesondere sind aufgrund der Erfassung der, beim Pre-Bonding Schritt eingebrachten Spannungen auch Vorhersagen der zu erwartenden Verzerrungen und der daraus resultierenden Abweichungen von der idealen Positionierung, insbesondere empirisch, abschätzbar.

Mit einer solchen Vorrichtung beziehungsweise einem solchen Verfahren sind Ausrichtungsgenauigkeiten von < 0,25 µm, insbesondere < 0,15 µm, vorzugsweise < 0,1 µm mit einer guten Sicherheit und Ausbeute realisierbar, indem die zuvor beschriebenen Verzerrungen kontrollierbar und gegebenenfalls vor dem Erzeugen der finalen Bondverbindung korrigierbar werden.

In anderen Worten stellt die Vorrichtung also zumindest Mittel zum Erfassen der Spannungseigenschaften der Wafer vor und/oder nach dem Pre-bonding Schritt zur Verfügung. Basierend auf der Kenntnis dieser Spannungseigenschaften und insbesondere einem Vergleich der Spannungseigenschaften vor und nach dem Pre-Bonding Schritt lassen sich Vorhersagen über Dehnungen/Verzerrungen, die während des Pre-Bonding Schrittes in die Wafer eingebracht wurden, treffen.

In einer weiteren Ausführungsform, insbesondere für die Inspektion und/oder die Ausrichtung von zwei strukturierten Wafern stellt die Vorrichtung Mittel zur Erfassung der Bewegung der Substrate, insbesondere ausschließlich in einer X- und Y-Richtung, zur Verfügung, die auf mindestens einen festen, insbesondere ortsfesten, Bezugspunkt bezogen sind und damit zumindest in einer X- und Y-Richtung eine exakte Ausrichtung der korrespondierenden Ausrichtungsschlüssel ermöglichen, und zwar nicht nur im Hinblick auf die Positionen der einzelnen Strukturen, sondern auch im Hinblick auf deren Dehnungs- und/oder Spannungseigenschaften.

Die Merkmale der hier vorgestellten Erfindung bestehen einerseits darin, dass die wirtschaftlich und/oder technisch optimalste Ausrichtung aller Strukturen beider Wafer zueinander bestimmbar, messbar und/oder überprüfbar ist. Dies umfasst die Aufnahme einer Positionskarte der Strukturen beider Wafer vor dem Zusammenführen der Wafer, insbesondere gemäß der früheren europäischen Patentanmeldung 09012023.9, sowie einen kontinuierlichen, insbesondere in-situ erfolgenden, Überwachungsprozess der Verschiebung der beiden Wafer über Ausrichtungsmarken. Bei fehlerhaftem prealignment und prebond können die meist sehr teuren Strukturwafer wieder voneinander getrennt und neu ausgerichtet werden.

In einer vorteilhaften Ausführungsform der Erfindung ist vorgesehen, dass die Einrichtung erste Positionskarten von ersten Ausrichtungsschlüsseln und/oder zweite Positionskarten von zweiten Ausrichtungsschlüsseln, insbesondere bei der Ermittlung durch die Auswertungsmittel, berücksichtigend ausgebildet ist. Als Ausrichtungsschlüssel kommen insbesondere die Alignment-Marken und/oder auf den Substraten oder einem der Substrate aufgebrachte Strukturen in Frage..

Die Aufnahme der Spannungs- und/oder Dehnungskarten erfolgt entweder von der jeweiligen Aufsichtsseite durch Reflexionsmessung, wobei die Strahlung reflektiert wird. Insbesondere wird kein Mittelwert der Spannung/Dehnung über die Schichtdicke, sondern eine Aussage über oberflächennahe Bereiche, Licht, Infrarot) oder von der jeweiligen Rückseite durch Transmissionsmessung erfindungsgemäß ermöglicht. Bei Messung mit Infrarotlicht oder Röntgen wird ein Mittelwert der Spannung oder Dehnung über die erfassbare Schichtdicke ermittelt. Durch die transparenten Bereiche wird nicht notwendigerweise eine Dehnungs-/Spannungskarte aufgenommen. Die Bestimmung der Positionskarten erfolgt insbesondere ausschließlich durch Reflexionsmessung, vorzugsweise durch Verwendung von sichtbarem Licht. Durch die vorgenannten Maßnahmen kann die Erfassung der ersten und zweiten Ausrichtungsschlüssel gleichzeitig, insbesondere mit ein und demselben Erfassungsmittel erfolgen.

Gemäß einer weiteren vorteilhaften Ausführungsform der Erfindung ist vorgesehen, dass die Ausrichtung der Substrate während des Kontaktierens und/oder Bondens der Substrate, insbesondere in-situ, überprüfbar ist. Die in-situ-Überprüfung bringt den Vorteil, dass, insbesondere durch Bewegung der Substrate verursachte Ausrichtungsfehler während des Kontaktierens oder Bondens ausgeschlossen werden können.

Soweit zur Überprüfung vier jeweils korrespondierende Ausrichtungsschlüssel vorgesehen sind, wobei die Überprüfung insbesondere durch transparente Bereiche hindurch erfolgt, kann auch eine gleichzeitige in-situ-Überwachung der Relativposition der Substrate zueinander erfolgen.

Weitere Vorteile, Merkmale und Einzelheiten der Erfindung ergeben sich aus der nachfolgenden Beschreibung bevorzugter Ausführungsbeispiele sowie anhand der Zeichnungen, diese zeigen in:
- Fig. 11a a: eine schematische Querschnittansicht eines erfindungsgemäß ausgerichteten Waferpaares,
- Fig. 11b: eine schematische Aufsicht auf einen oberen Wafer des Waferpaares gemäß Fig. 11a,
- Fig. 11c: eine schematische Aufsicht auf einen unteren Wafer des Waferpaares gemäß Fig. 11a,
- Fig. 12a: eine schematische Ansicht des erfindungsgemäßen Verfahrensschritts der Erfassung eines ersten Wafers,
- Fig. 12b: eine schematische Ansicht des erfindungsgemäßen Verfahrensschritts der Erfassung eines zweiten Wafers,
- Fig. 12c: eine schematische Ansicht der erfindungsgemäßen in-situ-Erfassung der Ausrichtung der Wafer beim Kontaktieren der Wafer,
- Fig. 13: eine vergrößerte Darstellung einer Ausrichtungsmarke bei einem perfekt ausgerichteten und kontaktierten Waferpaar,
- Fig. 14: eine vergrößerte Darstellung einer Ausrichtungsmarke bei einem nicht perfekt ausgerichteten und kontaktierten Waferpaar mit einer Vergrößerung von Ecken zweier auszurichtender Strukturen des Waferpaares
- Fig. 15a bis 15c: ein alternatives Verfahren zur Erfassung der Ausrichtung eines Waferpaares und
- Fig. 16: eine schematische Darstellung der erfindungsgemäßen Ermittlung einer Verschiebungskarte.

In den Figuren sind gleiche und gleichwirkende Bauteile/Merkmale mit den gleichen Bezugszeichen gekennzeichnet.

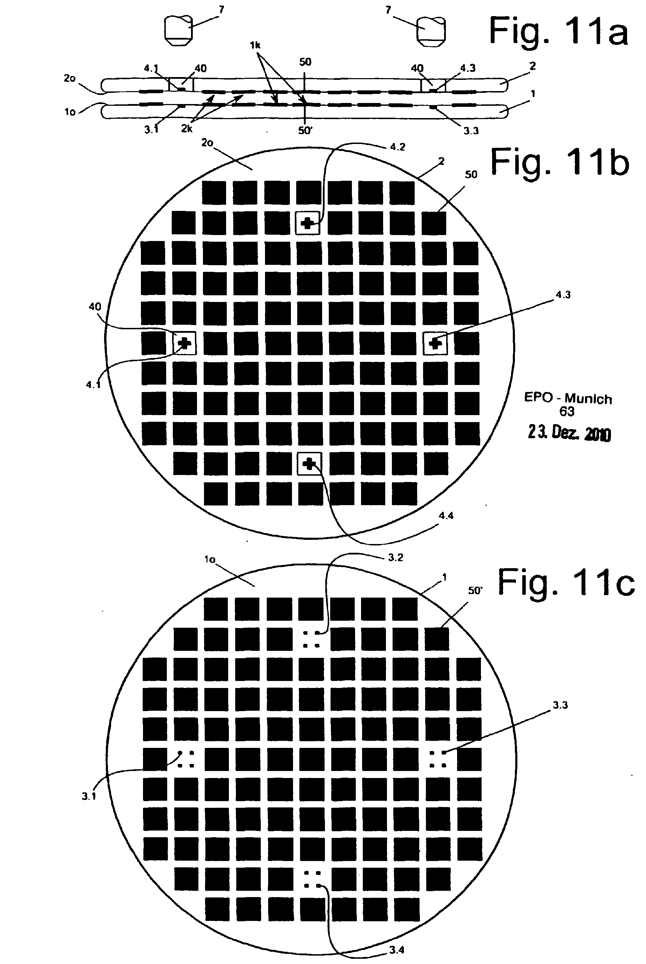

Figur 11a zeigt ein typisches Wafersystem, bestehend aus einem ersten Substrat 1, insbesondere einem Wafer 1, mit einer Oberfläche 1o, sowie einem zweiten Substrat 2, insbesondere einem Wafer, mit einer Oberfläche 2o. An den Oberflächen 10, 2o befinden sich unterschiedliche Strukturen 50, 50', die an den Kontaktflächen 1k, 2k gebondet werden sollen. Bei den Strukturen 50, 50' kann es sich beispielsweise um Kavitäten handeln, in denen sich MEMS-devices befinden. Im Falle von 3D integrierten Chip Stapel könnten die Strukturen auch Metallflächen sein, die zum Herstellen von elektrischen Verbindungen dienen. Der Einfachheit halber werden die Strukturen 50, 50' als schwarze Rechtecke dargestellt. Die Figuren 11b und 11c zeigen die Oberflächen 1o, 2o der beiden Wafer 1, 2. Der Wafer 2 besitzt vier Bereiche 40 mit zweiten Ausrichtungsschlüsseln 4.1 bis 4.4.

Die Bereiche 40 sind transparent für elektromagnetische Strahlung einer gewissen Wellenlänge oder eines gewissen Wellenlängenbereichs. Durch die transparenten Bereiche 40 kann ein erstes Erfassungsmittel 7, insbesondere eine Optik, die ersten Ausrichtungsschlüssel 3.1 bis 3.4 des ersten Wafers 1 mit den korrespondierenden zweiten Ausrichtungsschlüsseln 4.1 bis 4.4 korrelieren. Mit Vorteil können derartige transparente Bereiche für Siliziumwafer bereitgestellt werden, indem für diese Bereiche das Dotieren des Siliziums vermieden oder insbesondere der Dotierungsgrad ausreichend niedrig gehalten wird, sowie in diesen Bereichen keine Metall-Lagen aufgebracht werden beziehungsweise insbesondere ausreichend wenig Metallstrukturen erzeugt werden. Dies ist zum Beispiel dadurch erreichbar, dass in den transparenten Bereichen nur die Ausrichtungsmarken und etwaige zugehörige Strukturen platziert werden, die insbesondere aus Metall bestehen können. Unter Einhaltung dieser Voraussetzungen ist Silizium für Infrarot Licht mit einer Wellenlänge von >1µm, insbesondere >1050nm transparent.

Die Strukturen 50, 50' können die Oberflächen 1o, 2o überragen oder gegenüber diesen zurückgesetzt sein, weshalb die Kontaktflächen 1k, 2k nicht mit den Oberflächen 1o, 2o der Wafer 1, 2 zusammenfallen müssen.

Als Ausrichtungsschlüssel 3.1 bis 3.n beziehungsweise 4.1 bis 4.n kommen auch die Strukturen 50, 50' oder Teile der Strukturen 50, 50'in Frage.

Das Verfahren beginnt mit der Aufnahme der Positionskarten. Unter einer Positionskarte versteht man die räumlich möglichst vollständige Positionserfassung möglichst vieler struktureller Elemente, insbesondere der ersten und/oder zweiten Ausrichtungsschlüssel 3.1 bis 3.n oder 4.1 bis 4.n und/oder Strukturen 50, 50' oder Teile der Strukturen 50, 50', an der Oberfläche der Wafer 1, 2.

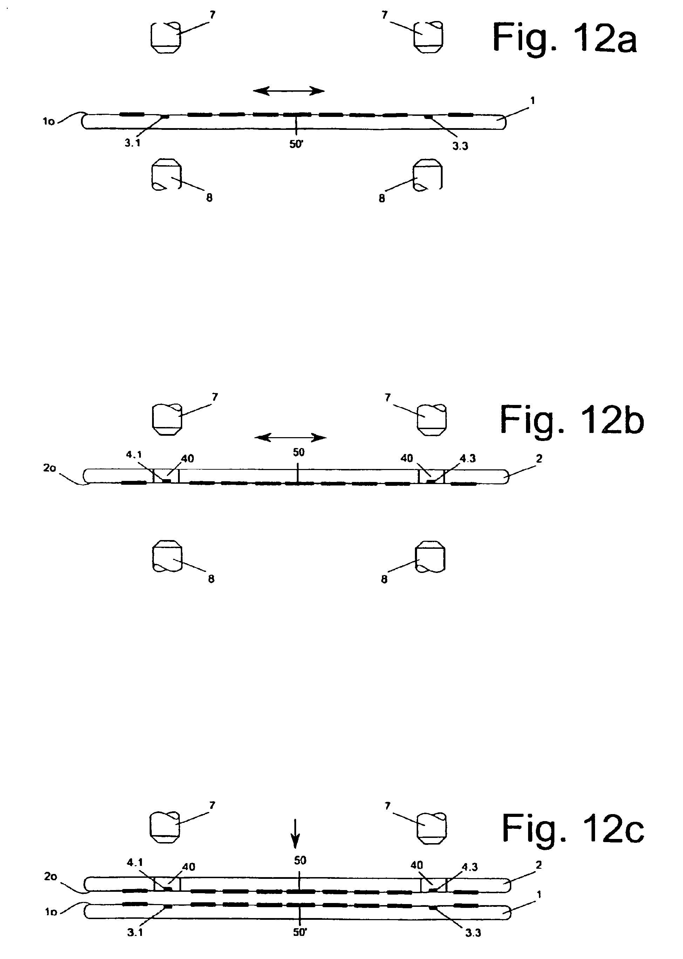

In Fig. 12a ist die Positionserfassung der Oberfläche 1o des ersten Wafers 1 durch die Optiken 7 dargestellt, also die Aufnahme einer ersten Positionskarte. Es werden Positionen der ersten Ausrichtungsschlüssel 3.1 bis 3.4 an der Oberseite 1o des Wafers 1 vermessen, indem entweder der Wafer 1 relativ zur Optik 7 oder die Optik 7 relativ zum Wafer 1 bewegt wird. In einer bevorzugten Ausführungsform sind die Optiken 7 fix, während der Wafer 1 relativ zu den Optiken 7, auf dem Aufnahmemittel 12 fixiert, bewegt wird.

In einem zweiten, sich insbesondere an den ersten Schritt anschließenden oder gleichzeitig mit diesem ablaufenden Schritt gemäß Figur 12b wird derselbe Vorgang mit der Oberseite 2o des zweiten Wafers 2 mittels eines zweiten Erfassungsmittels, insbesondere einer Optik 8 durchgeführt.

Da es bei diesem Vermessungsvorgang auf die Aufnahme der Positionskarte ankommt, wäre es auch vorstellbar, nur die Optiken 7 als Erfassungsmittel zu verwenden, also auf die Optiken 8 zu verzichten, und beide Wafer 1, 2 mit deren strukturierten Oberseiten 1o, 2o in Richtung der Optiken 7 zu vermessen. Für den späteren Ausrichtungs- und Bondschritt würde dann einer der beiden Wafer 1, 2 gewendet (flip) werden und auf seinem Aufnahmemittel 12 oder 22 fixiert werden.

Nach den oben beschriebenen Schritten kennt die Vorrichtung nun die X-Y-Positionen aller aufgenommenen Strukturen 50, 50' beziehungsweise aufgenommenen ersten und zweiten Ausrichtungsschlüssel 3.1 bis 3.n und 4.1 bis 4.n auf den Oberseiten 1o, 2o der Wafer 1. 2, insbesondere auch die Positionen der Strukturen 50, 50' relativ zu den ersten und zweiten Ausrichtungsschlüssel 3.1 bis 3.n und 4.1 bis 4.n. Diese werden in Form einer ersten Positionskarte für das erste Substrat 1 und in Form einer zweiten Positionskarte für das zweite Substrat 2 gespeichert.

Während des Vermessungsschritts sollen erfindungsgemäß nicht nur die erste und zweite Positionskarte, sondern, insbesondere in verschiedenen Modulen oder gleichzeitig in einem Modul, auch erste und zweite Ausgangsdehnungs- und/oder erste und zweite Ausgangsspannungskarten aufgenommen werden, die für die Grundspannungen oder Ausgangsspannungen der Substrate 1, 2 repräsentativ sind. Dabei handelt es sich um die Aufnahme von Dehnungs- und/oder Spannungswerten als Funktion der X-Y-Position gemäß der Positionskarte. Jedes Messgerät, welches in der Lage ist, Dehnungen und/oder Spannungen ortsaufgelöst zu bestimmen, kann verwendet werden, insbesondere Infrarotmessgeräte. Besonders vorteilhaft werden Messgeräte verwendet, die auf der Raman-Spektroskopie basieren. Alternativ ist erfindungsgemäß die Infrarot Methode "Grey-Field Polariscope" Review of Scientific Instruments 76, 045108 (2005) "Infrared grey-field polariscope: A tool for rapid stress analysis in microelectronic materials and devices." anwendbar. Die Aufnahme der Dehnungs- und/oder Spannungskarten erfolgt wiederum durch Relativbewegung der Optiken 7, 8 zu den Wafern 1,2. In vorteilhafter Ausführungsform ist für die Erfassung eine saparate oder in die Optiken 7, 8 zusätzlich integrierte Optik vorgesehen.

Soweit zur Optimierung der Erfassungszeit nur Dehnungskarten oder nur Spannungskarten erstellt werden, ist die Dehnungskarte in die korrespondierende Spannungskarte mittels der Fundamentalgleichungen der Elastizitätstheorie umrechenbar und umgekehrt. Eine mathematische, insbesondere numerische, Umrechnung, vorzugsweise mit Ansätzen nach der Methode der finiten Elemente, ist erfindungsgemäß denkbar.

Für Vorrichtungen, die optimiert wurden für die besonders präzise Erfassung der Positonskarten und/oder Spannungskarten kommen für die Erfassung der Positionskarten und der Spannungskarten zwei unterschiedliche Erfassungsmittel zum Einsatz.

Gemäß der Erfindung und zum Ausschluss weiterer Fehlerquellen ist vorgesehen, dass die Erfassung der Dehnungs- und/oder Spannungskarten nach der Ausrichtung der Substrate 1, 2 erfolgt.

Die jeweiligen Erfassungsmittel zur Aufnahme der Positionskarten umfassen in vorteilhafter Ausgestaltung gleichzeitig die Erfassungsmittel zur Erfassung der Dehnungs- und/oder Spannungskarten, so dass eine Bewegung der jeweiligen Erfassungsmittel mit ein und demselben Antrieb erfolgt.

Alternativ ist es zur beschleunigten und insofern kostengünstigeren Ausführungsform denkbar, die Erfassung der Dehnungs und/oder Spannungskarten in einem oder mehreren separaten Modulen vorzusehen, insbesondere mit jeweils separaten Waferhandhabungseinrichtungen, vorzugsweise Roboterarmen.

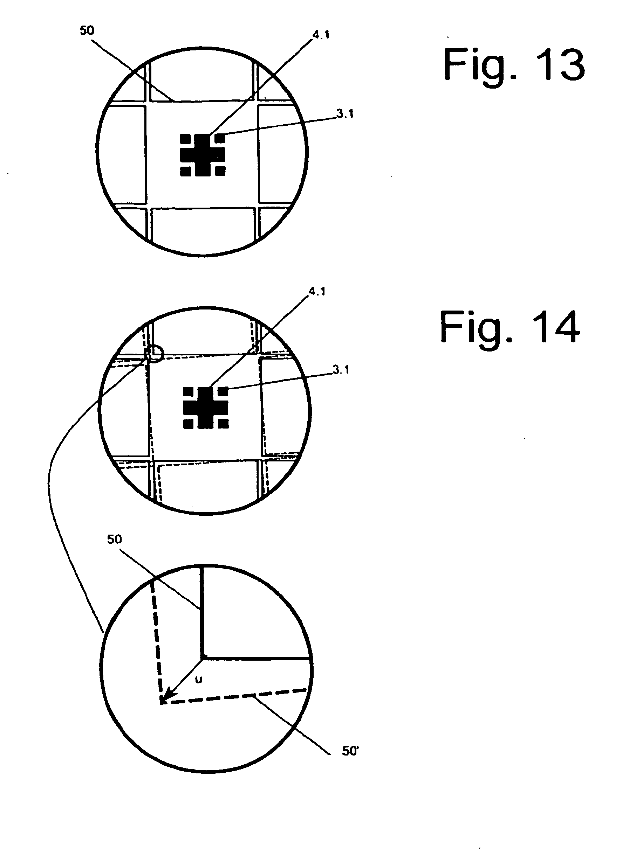

In Figur 13 sind perfekt ausgerichtete erste und zweite Ausrichtungsschlüssel 3.1 und 4.1 dargestellt, ebenso wie perfekt ausgerichtete Strukturen 50, 50', wobei die Struktur 50' wegen der perfekten Überdeckung von der Struktur 50 verdeckt ist. Der Fall, dass alle Strukturen 50, 50' auf beiden Wafern 1,2 in Bezug auf die Ausrichtungsschlüssel 3.1 bis 3.n und 4.1 bis 4.n so perfekt gefertigt worden sind, dass sich bei einem perfekten Bondprozess der Zustand aus Fig. 3 ergibt, ist unrealistisch. In Wirklichkeit können die Strukturen 50, 50' nicht so exakt gefertigt werden. Selbst wenn sie so perfekt gefertigt wären, könnten sich die Wafer 1, 2 während des Annäherungsprozesses oder während des "In-Kontakt-Tretens" zueinander verschieben. Auch beim Pre-Bonding Schritt können zusätzliche Spannungen in die Wafer eingebracht werden, die zu Dehnungen/Verzerrungen und in weiterer Konsequenz zu Abweichungen von der idealen Ausrichtung führen. Erfindungsgemäß wird dementsprechend nicht notwendigerweise eine perfekte Ausrichtung an einzelnen Positionen angestrebt. Vielmehr soll erfindungsgemäß dafür Sorge getragen werden, dass alle korrespondierenden Strukturen 50, 50' auf den Wafern 1, 2 bezogen auf wirtschaftliche und/oder technische Aspekte insgesamt so ausgerichtet werden, dass sich bei jedem auszurichtenden und zu bondenden Waferpaar ein kleinstmöglicher Ausschuss an Dices ergibt.

Da die Positionen aller erfassten Strukturen 50, 50' und/oder der ersten und zweiten Ausrichtungsschlüssel 3.1 bis 3.4 und 4.1 bis 4.4 beider Wafer 1, 2 bekannt sind, ist die optimale Relativposition der Wafer 1, 2 beziehungsweise aller Strukturen 50, 50' zueinander durch Berechnungsmittel bestimmbar. Dies erfolgt durch Ermittlung einer ersten Ausrichtungsposition der ersten Kontaktfläche 1k und einer zweiten Ausrichtungsposition der zweiten Kontaktfläche 2k auf Grundlage der Werte der ersten Positionskarte und auf Grundlage der Werte der zweiten Positionskarte Diese relative Position der Wafer 1, 2 zueinander und/oder die erste und zweite Ausrichtungsposition ist während und auch nach dem Kontaktieren und während sowie nach dem Bondingprozess durch die Optik 7 und durch die Transparenzbereiche 40 hindurch kontinuierlich auf Korrektheit überprüfbar. Hierdurch ist die Ausrichtung in-situ überprüfbar.

Die optimale Relativposition der beiden Wafer 1, 2 beziehungsweise der Strukturen 50, 50' zueinander ergibt sich beispielsweise durch Berechnung einer minimalen Summe der, insbesondere quadratischen, Abweichungen der jeweils korrespondierenden Strukturen 50, 50' voneinander.

Erfindungsgemäß ist es ebenfalls denkbar, in diese Berechnung der idealen Ausrichtungsposition auch wirtschaftliche Aspekte einfließen zu lassen. So ist es in manchen Bereichen der Halbleiterindustrie, insbesondere in der Speicherindustrie (z.B. DRAM, NAND Flash) üblich, dass Chips auf bestimmten Regionen innerhalb des Wafers, insbesondere im Bereich des Wafer Zentrums, eine geringere Streuung von qualitätsrelevanten Parametern aufweisen. Daher erzielen die Chips, die aus diesem Bereich stammen höhere Verkaufspreise, so dass dem mit einem Sortiervorgang, bei dem diese Chips bewusst in verschiedene Qualitätskörbe eingeteilt werden, Rechnung getragen wird. (im Englischen dieser Vorgang unter dem Begriff "Binning" bekannt). Mit Vorteil wird also erfindungsgemäß die ideale Ausrichtungsposition der Wafer nun nicht nur aufgrund der Positionskarten beider Wafer berechnet, sondern es fließt nun auch eine wirtschaftliche Berechnung/Gewichtung mit ein, bei der insbesondere dem Erreichen einer höheren Ausbeute im Bereich der höherwertigen Chips, insbesondere zu Lasten einer geringeren Ausbeute im Bereich der niedrig wertigeren Chips Sorge getragen wird.

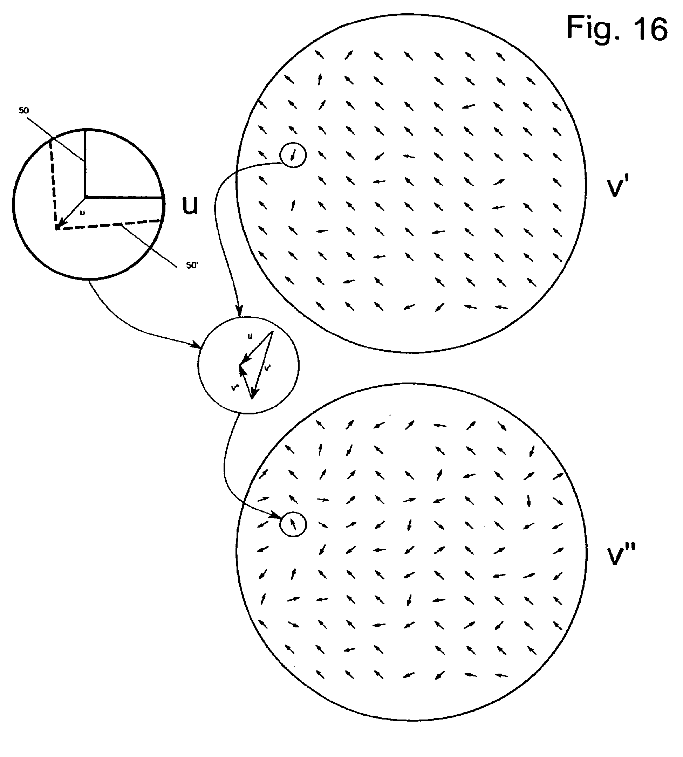

Die Figuren 14 und 16 zeigt einen Differenzvektor u, welcher die Differenz der X-Y-Positionen der Ecken einer oberen Struktur 50 mit denen einer korrespondierenden unteren Struktur 50' darstellt. Der Differenzvektor u ergibt sich beispielsweise aus der Minimierungsberechnung der Positionskarten. Natürlich wird in jedem der transparenten Bereiche 40 ein eigener Differenzvektor u erkennbar sein. Nähern sich nun die beiden Wafer aneinander an, werden die Differenzvektoren u kontinuierlich überprüft. Ändern sie sich, ist während der Annäherung oder während des Kontaktierens oder Bondens eine Abweichung von der ermittelten Relativposition der beiden Wafer 1, 2 zueinander erfolgt. Selbst wenn die beiden Wafer 1, 2 kontaktieren, können die Optiken 7 durch die Transparenzbereiche 40 zumindest die vier Differenzvektoren u noch überprüfen. Sollte nach dem Kontakt eine Abweichung erfolgt sein, die zu groß ist, werden die Wafer 1, 2 sofort wieder getrennt, um die Ausrichtung und den Prebondprozess erneut durchzuführen. Um eine gleichzeitige Überprüfung mehrerer Transparenzbereiche 40 zu realisieren, ist für jeden Transparenzbereich 40 eine eigene Optik 7 vorgesehen, damit der Durchsatz beim Bonden durch die in-situ-Erfassung der Ausrichtung nicht reduziert wird.

Alternativ ist es erfindungsgemäß auch denkbar, den Überprüfungsschritt nach dem Pre-Bonding in einem separaten Modul durchzuführen, so dass der Durchsatz der Ausrichtungseinrichtung und des Pre-Bonding Moduls nicht reduziert wird. Das etwaige Trennen der Wafer nach dem Überprüfungsschritt kann entweder in dem, für die Überprüfung vorgesehenen Modul geschehen oder aber ebenfalls in einem separaten Modul. Es ist auch denkbar, dass nicht alle Module in einem einzigen Gerät verbunden sind, sondern separate Geräte, insbesondere mit jeweils separaten Waferhandhabungseinrichtungen, bilden.

Fig. 13 zeigt in der Vergrößerung den Nahbereich der Ausrichtungsmarken 3.1 und 4.1. Um die Strukturen 50 und 50' bei Überlagerung erkennen zu können, wurden nur die Umrandungen eingezeichnet. Wären nun die Strukturen 50 und 50' perfekt zueinander, sowie perfekt zu den Ausrichtungsmarken 3.1 und 4.1 orientiert, würde man bei einem Bondprozess eine perfekte Deckung beider Strukturen 50 und 50' feststellen.

Fig. 14 zeigt den Beispielfall, bei dem es zu keiner Deckung der Strukturen 50 und 50' kommt, obwohl die Ausrichtungsmarken 3.1 und 4.1 perfekt zueinander ausgerichtet worden sind. In der Vergrößerung der Struktur 50 und der korrespondierenden Struktur 50' ist erkennbar, dass der Differenzvektor u eine X und eine Y-Komponente besitzt, die zur Vektorberechnung verwendet werden können.

Wesentlicher Bestandteil der vorliegenden Erfindung besteht darin, dass die oben genannten Messinstrumente oder in einem separaten Modul vorgesehene Messinstrumente zur Dehnungs- und/oder Spannungsmessung nach dem Pre-Bonden oder Bonden eingesetzt werden können, um die Dehnungs- und/oder Spannungskarten des gebondeten Waferstapels zu bestimmen. Durch die Messung der Ausgangsdehnungs- und/oder Ausgangsspannungskarten der Wafer 1, 2 vor dem Bonden beider Wafer 1, 2 zu dem Waferstapel und der Messung der Dehnungs- und/oder Spannungskarten des Waferstapels können Rückschlüsse auf die Verformung im Kontaktzeitpunkt oder kurz danach getätigt werden. In anderen Worten kann also die durch den Pre-Bonding Prozess eingebrachte Spannung gemessen und die daraus resultierende Dehnung/Verzerrung ermittelt/abgeschätzt/vorhergesagt oder mit Vorteil berechnet, insbesondere basierend auf empirisch ermittelten Zusammenhängen berechnet, werden. Obwohl also die inneren Bereiche der Wafer 1, 2nicht mehr mit den Optiken 7, 8 einsehbar sind, da sich in diesem Bereich keine transparenten Bereiche 40 befinden, kann durch die Dehnungs- und/oder Spannungskarten auf den Zustand, die Position oder die Verformung in diesem Bereich rückgeschlossen werden. Herrscht beispielsweise in einem Bereich eine Spannung vor, die einen kritischen Wert, beispielsweise den Wert einer Vergleichsspannung, überschreitet, kann dieser Bereich von einer Software automatisch als Problemzone markiert werden. Die Dices könnten so in Güteklassen eingeteilt werden. Dices mit geringen Eigenspannungen haben eine hohe Güteklasse sowie lange Lebensdauer, während Dices mit hohen Spannungskonzentrationen in eine niedrige Güteklasse einstufbar sind. Basierend auf diesen Spannungs-/Dehnungskarten erfolgt für die gesamte Waferfläche und alle darauf vorhandenen Strukturen eine Abschätzung oder empirische Ermittlung der erzielten Ausrichtungsgenauigkeit. Dies kann in der Praxis wie folgt realisiert werden:
1) Erfassen der ersten und zweiten Positionskarten, korrespondierend mit dem ersten und zweiten Wafer wie zuvor beschrieben.
2) Errechnen der idealen Ausrichtungsposition basierend auf dieser ersten und zweiten Positionskarte gemäß technischen und/oder wirtschaftlichen Kriterien. Aus dieser Berechnung gehen ebenfalls die idealen Ausrichtungspositionen und die korrespondierenden Abweichungsvektoren für die Ausrichtungsmarken in den transparenten Bereichen 40 hervor. Das heißt, die Ausrichtungsmarken in den transparenten Bereichen 40 müssen nicht notwendigerweise perfekt ausgerichtet sein, um für den Gesamtwafer gesehen das optimale Ergebnis zu erreichen. Weiters wird basierend auf dieser errechneten, angestrebten Ausrichtungsposition auch ein dadurch zu erwartendes zweidimensionales Differenzvektorfeld v' (siehe Fig. 16) mit einzelnen Differenzvektoren für zumindest die überwiegende Zahl, vorzugsweise alle, in den Positionskarten enthaltenen Positionen errechnet. Dabei werden vorzugsweise Stellen, an welchen keine Strukturen 50, 50' vorgesehen sind, ausgelassen, um das Messergebnis nicht zu verfälschen. Dies sind beispielsweise die Stellen der Ausrichtungsschlilssel 3.1 bis 3.4 und 4.1 bis 4.4, da dort statt Strukturen 50, 50' Alignmentmarken vorgesehen sind.
3) Erfassen der ersten und zweiten Ausgangsspannungskarte, korrespondierend mit dem ersten und zweiten Wafer vor dem Pre-Bonding Schritt, insbesondere parallel zum Erfassen der ersten und zweiten Positionskarte.
4) Pre-Bonden der Wafer mit einem geeigneten Verfahren. Diese Verfahren sind in grundsätzlicher Form dem Fachmann für verschiedenste Bonding Verbindungen bekannt.
5) Erfassen der tatsächlichen Ausrichtungsgenauigkeit in den transparenten Bereichen 40 und Ermitteln der tatsächlichen Abweichungsvektoren u in den transparenten Bereichen.
6) Ermitteln der Differenz zwischen den tatsächlichen Abweichungsvektoren u mit den errechneten Abweichungsvektoren für die transparenten Bereiche 40.
7) Unter Berücksichtigung der ermittelten Differenz ist die daraus resultierende Differenzvektorkarte v" errechenbar, in der für zumindest die überwiegende Zahl, insbesondere für jede, in der ersten und zweiten Positionskarte enthaltene Position ein Abweichungsvektor vorhanden ist. Diese, zu den einzelnen Positionen korrespondierenden Abweichungsvektoren u sind nun um einen Korrekturvektor angepasst, welcher für jede einzelne Position basierend auf den, unter Punkt 6 ermittelten Abweichungsvektoren sowie der Koordinatenposition des jeweiligen Punktes und der Koordinatenpositionen der Transparenzfelder errechnet wird.
8) Erfassen der ersten und zweiten Spannungskarte nach dem Pre-Bonden.
9) Vergleichen der ersten Spannungskarte vor und nach dem Pre-Bonden sowie der zweiten Spannungskarte vor und nach dem Pre-Bonden.
10) Vorhersage der, für die einzelnen Punke zu erwartenden zusätzlichen Ausrichtungsfehler / Abweichungsvektoren basierend auf den Spannungsunterschieden vor und nach dem Pre-Bonden.
11) Addieren der durch die beim Pre-Bonden eingebrachten Spannung verursachten zusätzlichen Abweichungsvektoren zu den theoretisch zu erwartenden Abweichungsvektoren, die im Punkt 7 errechnet wurden.
12) Entscheiden, ob die nun aufgrund der Berechnung in Punkt 11 vorhergesagtem Vektorfeld für die Abweichungsvektoren in den einzelnen Punkten zu erwartende Ausrichtungsgenauigkeit nach wie vor technologischen und wirtschaftlichen Erfolgskriterien entspricht oder ob eine Nachbearbeitung/Trennen der Wafer durchgeführt werden soll.

Für Wafer Stapel, in denen einer oder beide Wafer vor dem Pre-Bonden nur geringe oder insbesondere keine Ausgangsspannungen aufweisen, oder für die die Ausgangsspannung vor dem Bonden bekannt ist, weil diese beispielsweise nur einer in der Massenfertigung nur einer sehr geringen Streuung unterliegt, kann auf Schritt 3, das Erfassen der Spannungskarten vor dem Bonden im Sinne einer Optimierung des Durchsatzes und der Kosten verzichtet werden. Es ist erfindungsgemäß auch möglich, insbesondere im Falle von Spannungen, die nur einer geringen Streuung unterliegen, nur einen Teil der Wafer der Erfassung der Spannungskarten vor dem Bonden zu unterziehen. Unter geringen Spannungen in diesem Zusammenhang sind Spannungswerte zu verstehen, die insignifikant sind im Vergleich zu den, beim Pre-Bonding Schritt erzeugten Spannungen. Dies ist insbesondere dann der Fall, wenn die Spannungen um den Faktor 3, bevorzugt um den Faktor 5 oder noch besser um den Faktor 10 differieren. Hinsichtlich der nur teilweisen Messung der Waferstapel ist es insbesondere sinnvoll zum Beispiel den ersten und den letzten Waferstapel einer Charge der Inspektion zu unterziehen und für die restlichen Waferstapel die, für den ersten Waferstapel ermittelte Spannungskarte für die Berechnungen zugrunde zu legen. Es ist auch denkbar, die Berechnungen zeitversetzt durchzuführen, um dann die gemittelten Spannungskarten für beispielsweise den ersten und den letzten Waferstapel der Berechnung zugrunde zu legen. In diesem Fall ist es mit Vorteil auch möglich, weitere Waferstapel zusätzlich zu inspizieren um eine höhere Sicherheit bei der Berechnung des Mittelwertes zu erzielen. Entsprechend der beschriebenen Vorgehensweise ist es auch möglich, nur einen der beiden Wafer, die den Waferstapel bilden, der Erfassung der Spannungskarten zu unterziehen. Dies ist insbesondere dann von Vorteil, wenn nur einer der beiden Wafer die zuvor beschriebenen Kriterien, die das Weglassen der Spannungskartenerfassung rechtfertigen, nicht erfüllt.

Für Anwendungsfälle, bei denen nur einer der beiden Wafer strukturiert ist, kann das Verfahren ähnlich wie für das Bonden von zwei strukturierten Wafern erfolgen. Konkret ist in dieser Ausführungsform der Ablauf wie folgt:
1) Erfassen der bereits existierenden Verzerrung/Abweichungsvektoren der einzelnen, am strukturierten Wafer befindlichen Belichtungsfelder von der Idealform mittels geeigneter Erfassungsmittel. Insbesondere ermöglichen Step und Repeat Belichtungssysteme, die auch für eine spätere Bearbeitung der gebondeten Wafer vorgesehen sind, eine derartige Messung unter Zuhilfenahme von geeigneten Hilfsmitteln wie Testmasken. Diese Abweichung von der Idealform wird in Form eines Vektorfeldes dargestellt und für die weitere Berechnung gespeichert. Insbesondere enthält dieses Vektorfeld Vektoren für einen wesentlichen Teil, insbesondere alle Positionen der Ausrichtungsmarken, die sich üblicherweise an den Ecken der Belichtungsfelder befinden.
2) Erfassen der Ausgangsspannungskarte des strukturierten Wafers vor dem Pre-Bonding Prozess durch geeignete Erfassungsmittel von der, der Kontaktfläche 1k (falls Wafer 1 der strukturierte Wafer ist) oder 2k (falls Wafer 2 der strukturierte Wafer ist) gegenüberliegenden Seite.
3) Ausrichten der beiden Wafer zueinander unter Zuhilfenahme von geeigneten Erfassungsmitteln für die Waferposition und Ausrichtungsmitteln.
4) Pre-Bonding der beiden Wafer.
5) Erfassen der Spannungskarte des strukturierten Wafers nach dem Pre-Bonding Schritt mittels geeigneter Erfassungsmittel von der, der Kontaktfläche 1k / 2k gegenüberliegenden Seite.
6) Ermitteln der Differenz zwischen der Spannungskarte vor dem Pre-Bonding Schritt und nach dem Pre-Bonding Schritt.
7) Ableiten der zu erwartenden Verzerrungsvektoren / des zu erwartenden Verzerrungsvektorfeldes basierend auf der, in Punkt 6 ermittelten Spannungsdifferenz. Mit Vorteil werden die Vektoren in diesem Vektorfeld für Positionen bestimmt, die mit den Positionen der Vektoren aus dem Vektorfeld, welches in Punkt 1 ermittelt wurde, korrelieren, insbesondere zumindest weitgehend übereinstimmen. Mit Vorteil ist diese Übereinstimmung besser als 500µm, noch idealer jedoch besser als 200 oder 70µm.
8) Addieren des Verzerrungsvektorfeldes mit dem in Punkt 1 ermittelten Vektorfeld.
9) Überprüfen, ob das aus der Berechnung in Punkt 8 resultierende Vektorfeld nach wie vor technologischen und wirtschaftlichen Erfolgskriterien entspricht, oder ob ein Trennen und Nachbearbeiten der Wafer erfolgen soll.

Die zuvor gemachten Ausführungen bezüglich dem Weglassen der Erfassung der Spannungskarten vor dem Bonden beziehungsweise der nur teilweisen Erfassung der Spannungskarten für ausgewählte Wafer und/oder Waferstapel gelten hier analog.

Das Ableiten des Verzerrungsvektorfeldes aus den Spannungskarten und insbesondere den Karten für die Spannungsdifferenz zwischen, vor und nach dem Pre-Bonden kann erfindungsgemäß basierend auf einer Vielzahl von geeigneten Methoden geschehen. Aus der Erfassung der Spannungskarten und insbesondere der Spannungsdifferenz vorher/nachher ist ersichtlich, ob in bestimmten Bereichen des Wafers eine Druck oder Zugspannung während dem Bonden zusätzlich erzeugt wurde. Basierend darauf lassen sich Rückschlüsse über die Richtung der einzelnen Vektoren an jedem beliebigen Punkt des Wafers machen. Die Höhe der Spannungsdifferenz in den einzelnen Bereichen, die ebenfalls aus den Messungen und/oder der Berechnung bekannt ist, lässt Rückschlüsse auf den Betrag des Vektors zu. Diese Zusammenhänge sind jedoch nicht notwendigerweise linear, da die einzelnen Teilbereiche des Wafers üblicherweise von anderen Bereichen umgeben sind, die die Dehnung / Verzerrung des Wafers zusätzlich mit beeinflussen. Daher müssen in der Praxis geeignete, komplexe Rechenmodelle angewendet werden, um die tatsächlichen Beträge und Richtungen der Vektoren abschätzen zu können. Eine andere Möglichkeit für bestimmte Rahmenbedingungen (bestimmte Spannungswerte, etc.) ist auch die Verwendung von empirischen Verfahren, in denen die Erfahrungen aus, in der Vergangenheit durchgeführten Tests zu Nutze gezogen werden.

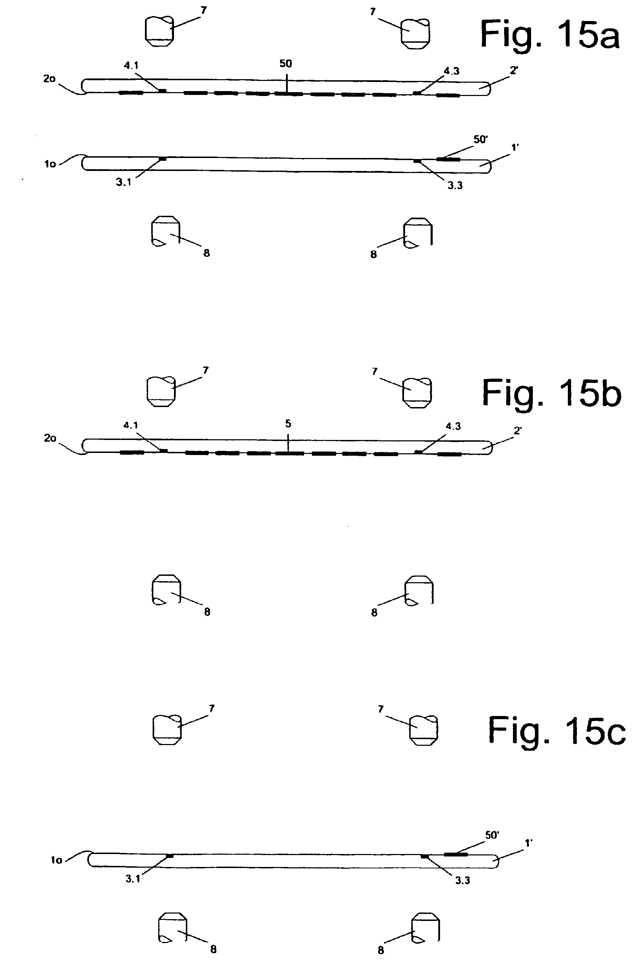

Ohne transparente Bereiche 40 ist die in-situ-Messung der Ausrichtung beim Kontaktieren und/oder Bonden auf die Messung der Dehnungs- und/oder Spannungsfelder beschränkt, wie es in Figuren 15a bis 15c dargestellt ist. Die Beispiele der Figuren 15a bis 15c zeigen ein Verfahren und eine Vorrichtung, bei welchen statt zweier Wafer 1, 2, die beide vollständig strukturiert sind, ein Strukturwafer 2' gegenüber einem Trägerwafer 1 ausgerichtet wird.

Die Ausrichtungsmarken 3.1 bis 3.n werden mit den Ausrichtungsmarken 4.1 bis 4.n korreliert, indem bereits bekannte optische Systeme verwendet werden. Die Optiken 7 und/oder 8 können, wenn sie über die entsprechenden Sensormittel verfügen, die oben bereits erwähnt wurden, zur Messung der Dehnungs- und/oder Spannungsfelder verwendet werden. Die Messung der Dehnungs- und/oder Spannungsfelder auf der Oberseite 2o des Wafers 2 kann entweder durch die Optiken 8 erfolgen, während der Trägerwafer 1 aus dem Sichtbereich entfernt wurde (Fig. 15b) oder aber durch die Optiken 7, sofern die verwendete elektromagnetische Strahlung den Strukturwafer 2' durchdringen kann. Es ist durch die Berechnungsmittel zu berücksichtigen, dass bei der Transmissionsmessung durch die Optiken 7 ein gemittelter Dehnungs- und/oder Spannungswert erhalten werden kann, sofern sich die Spannung entlang der Schichtdicke ändert (sogenannte Spannungsgradienten in der Schichtdicke). Für die Messung der Dehnungs- und/oder Spannungsfelder auf der Oberfläche 1o des Trägerwafers 1 gilt das Vorbeschriebene mutatis mutandis gemäß Figur 15c.

Nachdem die jeweiligen Ausgangsdehnungs- und/oder Ausgangsspannungsfelder vermessen wurden, können die beiden Wafer 1', 2'ausgerichtet und gebonded werden. Nachdem der Bond erfolgt ist, werden mittels der Optiken 7 und/oder 8 die Dehnungs- und/oder Spannungsfelder ermittelt werden. Nach dem Bonden ist nur mehr eine Transmissionsmessung der Dehnungs- und/oder Spannungsfelder der Oberflächen 1o, 2o möglich, da die elektromagnetische Strahlung beide Wafer 1', 2' durchdringen muss. Daher erfolgt auch die oben genannte Unterscheidung zwischen Transmissions- und Reflektionsmessung. Zur besseren Vergleichbarkeit wird erfindungsgemäß die Transmissionsmessung bevorzugt. Sollten Transmissionsmessungen und Reflektionsmessungen ähnliche Dehnungs- und/oder Spannungskarten ergeben, kann gefolgert werden, dass sich die Dehnungs- und/oder Spannungsfelder nur an den Oberflächen 1o, 2o befinden und es keine Spannungsgradienten über die Dicke gibt. Der Vorher/Nacher-Vergleich erlaubt dann wiederum eine Aussage über die Änderung der Dehnungs- und/oder Spannungsfelder und Rückschlüsse auf mögliche Schwachstellen des Systems. Sollten extreme oder einen Vergleichswert überschreitende Dehnungs- und/oder Spannungsbereiche entdeckt werden, kann das Wafersystem wieder in die Einzelwafer zerlegt werden, bevor diese permanent miteinander gebonded werden.

Für strukturierte Wafer, die nicht transparent für die zur Erfassung der Spannungskarten verwendeten elektromagnetischen Wellen sind, ist eine Reflektionsmessung zu bevorzugen, da damit die Transparenz der strukturierten Oberfläche des Wafers, insbesondere der Kontaktfläche 1 k oder 2k, keine Rolle spielt. Für derartige Wafer mit mangelnder Transparenz kann mit Vorteil auch die Spannung an den den Oberflächen 1o und 2o gegenüberliegenden Flächen gemessen werden. Um eine bessere Vergleichbarkeit der Messresultate zu erzielen, ist es sinnvoll, sowohl vor und nach dem Pre-Bonding und/oder dem Bonding Schritt an diesen Oberflächen zu messen. Da die Spannungsfelder im Wafer in lateraler Richtung gesehen im Vergleich zur Waferdicke eine wesentlich größere Ausdehnung besitzen, gibt auch diese Variante der Messung sehr gute Resultate. Insbesondere der Umstand, dass es lateraler Spannungsfelder mit einer bestimmten Mindestausdehnung bedarf, um signifikante Verzerrungen zu verursachen, wirkt sich positiv auf die Genauigkeit aus. Es ist zu erwarten, dass Spannungsfelder in lateraler Richtung (X/Y) mindestens eine 3 bis 5 mal, mit Wahrscheinlichkeit sogar 10, 15 oder 20 mal so große Ausdehnung haben müssen bezogen auf die Waferdicke, um zu relevanten Dehnungen / Verzerrungen zu führen.

Die wichtigsten, erfindungsgemäß verwendbaren Wafermaterialkombinationen sind: Cu-Cu, Au-Au, Hybrid Bonds, Si, Ge, InP, InAs, GaAs; sowie Kombinationen aus diesen Materialien und den jeweils zuordenbaren Oxiden für Materialien, die dies zulassen.

Die Positions- Dehnungs- und Spannungskarten beziehen sich in vorteilhafter Weise alle auf dasselbe X-Y-Koordinatensystem. Somit wird die Vektorberechnung, insbesondere bei der Bestimmung der ersten und zweiten Ausrichtungspositionen und der Ermittlung der Verschiebungskarte gemäß Figur 16 vereinfacht.

Einrichtung, Vorrichtung und Verfahren zur Ermittlung von Ausrichtungsfehlern

### Bezugszeichenliste

- 1: erstes Substrat
- 1k: erste Kontaktfläche
- 2: zweites Substrat
- 2k: zweite Kontaktfläche
- 3.1 bis 3.n: erste Ausrichtungsschlüssel
- 4.1 bis 4.n: zweite Ausrichtungsschlüssel
- 7: erste Erfassungsmittel
- 8: zweite Erfassungsmittel
- 1o: Oberfläche
- 2o: Oberfläche
- 1': Trägerwafer
- 2': Strukturwafer
- 40: transparente Bereiche
- 50, 50': Strukturen
- u: Differenzvektor
- v', v": Abweichungsvektoren

## Patentansprüche

1. Einrichtung zur Ermittlung von durch Dehnung und/oder Verzerrung eines ersten Substrats (1) gegenüber einem zweiten Substrat (2) beim Verbinden des ersten Substrats (1) mit dem zweiten Substrat (2) aufgetretenen lokalen Ausrichtungsfehlern mit folgenden Merkmalen:
- eine erste Dehnungskarte von Dehnungswerten entlang einer ersten Kontaktfläche (1k) des ersten Substrats (1) und/oder eine erste Spannungskarte von Spannungswerten entlang der ersten Kontaktfläche (1k) ist/sind durch Erfassungsmittel erfassbar und/oder
- eine zweite Dehnungskarte von Dehnungswerten entlang einer zweiten Kontaktfläche (2k) und/oder eine zweite Spannungskarte von Spannungswerten entlang der zweiten Kontaktfläche (2k) ist/sind durch die Erfassungsmittel erfassbar und
- Auswertungsmittel zur Auswertung der ersten und/oder zweiten Dehnungskarten und/oder ersten und/oder zweiten Spannungskarten, durch welche die lokalen Ausrichtungsfehler ermittelbar sind.

2. Einrichtung nach Anspruch 1, die erste Positionskarten von ersten Ausrichtungsschlüsseln (3.1 bis 3.n) und/oder zweite Positionskarten von zweiten Ausrichtungsschlüsseln (4.1 bis 4.n), insbesondere bei der Ermittlung durch die Auswertungsmittel, berücksichtigend ausgebildet ist.

3. Vorrichtung zur Ermittlung von durch Dehnung und/oder Verzerrung eines ersten Substrats (1) gegenüber einem zweiten Substrat (2) beim Bonden oder Prebonden des ersten Substrats (1) mit dem zweiten Substrat (2) aufgetretenen lokalen Ausrichtungsfehlern mit folgenden Merkmalen:
- eine erste Ausgangsdehnungskarte von Dehnungswerten entlang einer ersten Kontaktfläche (1k) des ersten Substrats (1) und/oder eine erste Ausgangsspannungskarte von Spannungswerten entlang der ersten Kontaktfläche (1k) ist/sind durch Ausgangserfassungsmittel erfassbar und/oder
- eine zweite Ausgangsdehnungskarte von Dehnungswerten entlang einer zweiten Kontaktfläche (2k) und/oder eine zweite Ausgangsspannungskarte von Spannungswerten entlang der zweiten Kontaktfläche (2k) ist/sind durch die Ausgangserfassungsmittel erfassbar und
- die Einrichtung gemäß Anspruch 1, wobei die ersten und/oder zweiten Ausgangsdehnungskarten und/oder die ersten und/oder zweiten Ausgangsspannungskarten durch die Auswertungsmittel bei der Ermittlung der lokalen Ausrichtungsfehler berücksichtigbar sind.

4. Vorrichtung zum Verbinden einer ersten Kontaktfläche (1k) eines auf einer ersten Plattform (10) aufnehmbaren ersten Substrats (1) mit einer zweiten Kontaktfläche (2k) eines auf einer zweiten Plattform (20) aufnehmbaren zweiten Substrats (2) mit folgenden Merkmalen:
- eine erste Positionskarte von entlang der ersten Kontaktfläche (1k) angeordneten ersten Ausrichtungsschlüsseln (3.1 bis 3.n, 50') ist durch Positionserfassungsmittel (7, 8) erfassbar,
- eine zweite Positionskarte von entlang der zweiten Kontaktfläche (2k) angeordneten zweiten Ausrichtungsschlüsseln (4.1 bis 4.n, 50) ist durch die Positionserfassungsmittel (7, 8) erfassbar,
- die Einrichtung gemäß Anspruch 1 oder 2 oder die Vorrichtung gemäß Anspruch 3,
- Berechnungsmittel zur Ermittlung einer ersten Ausrichtungsposition der ersten Kontaktfläche (1k) und einer zweiten Ausrichtungsposition der zweiten Kontaktfläche (2k) auf Grundlage der Werte der ersten Positionskarte und der Werte der zweiten Positionskarte
- Ausrichtungsmittel zur Ausrichtung der ersten Kontaktfläche (1k) in die erste Ausrichtungsposition und der zweiten Kontaktfläche (2k) in die zweite Ausrichtungsposition und
- Mittel zum Verbinden des ersten und zweiten Substrats (1, 2).

5. Vorrichtung nach Anspruch 4, **dadurch gekennzeichnet, dass** Erfassungsmittel zur Prüfung der ersten und/oder zweiten Ausrichtungspositionen während des Verbindens der Substrate (1, 2), insbesondere in-situ, vorgesehen sind

6. Vorrichtung nach Anspruch 5, bei der die Prüfung durch transparente Bereiche (40) des ersten Substrats (1) und/oder des zweiten Substrats (2) hindurch erfolgt.

7. Vorrichtung nach Anspruch 5 oder 6, **dadurch gekennzeichnet, dass** zur Prüfung mindestens zwei, vorzugsweise vier jeweils korrespondierende Ausrichtungsschlüssel (3.1 bis 3.4, 4.1 bis 4.4) vorgesehen sind.

8. Verfahren zur Ermittlung von durch Dehnung und/oder Verzerrung eines ersten Substrats (1) gegenüber einem zweiten Substrat (2) beim Verbinden des ersten Substrats (1) mit dem zweiten Substrat (2) aufgetretenen lokalen Ausrichtungsfehlern mit folgenden Schritten, insbesondere folgendem Ablauf:
- Erfassung einer ersten Dehnungskarte von Dehnungswerten entlang einer ersten Kontaktfläche (1k) des ersten Substrats (1) und/oder einer ersten Spannungskarte von Spannungswerten entlang der ersten Kontaktfläche (1k) durch Erfassungsmittel und/oder
- Erfassung einer zweiten Dehnungskarte von Dehnungswerten entlang einer zweiten Kontaktfläche (2k) und/oder einer zweiten Spannungskarte von Spannungswerten entlang der zweiten Kontaktfläche (2k) durch die Erfassungsmittel und
- Auswertung der ersten und/oder zweiten Dehnungskarten und/oder ersten und/oder zweiten Spannungskarten durch Auswertungsmittel und Ermittlung der lokalen Ausrichtungsfehler.

9. Verfahren nach Anspruch 8, wobei bei der Auswertung erste Positionskarten von ersten Ausrichtungsschlüsseln (3.1 bis 3.n, 50') und/oder zweite Positionskarten von zweiten Ausrichtungsschlüsseln (4.1 bis 4.n, 50), insbesondere bei der Ermittlung, berücksichtigt werden.

10. Verfahren nach Anspruch 8 oder 9, bei dem folgende weitere Schritte vorgesehen sind:
- Erfassung einer ersten Ausgangsdehnungskarte von Dehnungswerten entlang der ersten Kontaktfläche (1k) und/oder einer ersten Ausgangsspannungskarte von Spannungswerten entlang der ersten Kontaktfläche (1k) durch Ausgangserfassungsmittel vor dem Verbinden und/oder
- Erfassung einer zweiten Ausgangsdehnungskarte von Dehnungswerten entlang der zweiten Kontaktfläche (2k) und/oder einer zweiten Ausgangsspannungskarte von Spannungswerten entlang der zweiten Kontaktfläche (2k) durch die Ausgangserfassungsmittel vor dem Verbinden und
- Berücksichtigung der ersten und/oder zweiten Ausgangsdehnungskarten und/oder die ersten und/oder zweiten Ausgangsspannungskarten durch die Auswertungsmittel bei der Ermittlung der lokalen Ausrichtungsfehler.

11. Verfahren nach einem der Ansprüche 8 bis 10, bei dem folgende weitere Schritte vorgesehene sind:
- Erfassung einer ersten Positionskarte von entlang der ersten Kontaktfläche (1k) angeordneten ersten Ausrichtungsschlüsseln (3.1 bis 3.n, 50')durch Positionserfassungsmittel (7, 8) vor dem Verbinden,
- Erfassung einer zweiten Positionskarte von entlang der zweiten Kontaktfläche (2k) angeordneten zweiten Ausrichtungsschlüsseln (4.1 bis 4.n, 50) durch die Positionserfassungsmittel (7, 8) vor dem Verbinden
- Ermittlung einer ersten Ausrichtungsposition der ersten Kontaktfläche (1k) und einer zweiten Ausrichtungsposition der zweiten Kontaktfläche (2k) auf Grundlage der Werte der ersten Positionskarte und der Werte der zweiten Positionskarte durch Berechnungsmittel,
- Ausrichtung der ersten Kontaktfläche (1k) in die erste Ausrichtungsposition und der zweiten Kontaktfläche (2k) in die zweite Ausrichtungsposition durch Ausrichtungsmittel und
- Verbinden des ersten und zweiten Substrats (1, 2)

12. Verfahren nach einem der Ansprüche 8 bis 11, bei dem folgender weiterer Schritt vorgesehene ist:
- Prüfung der ersten und/oder zweiten Ausrichtungspositionen während des Verbindens der Substrate (1, 2), insbesondere in-situ, durch Erfassungsmittel, insbesondere durch transparente Bereiche (40) des ersten Substrats (1) und/oder des zweiten Substrats (2) hindurch.

13. Verwendung der Einrichtung nach Anspruch 1 oder der Vorrichtung nach Anspruch 4 für überarbeitbare oder zu überarbeitende, gebondete Wafer (1, 2).

14. Verfahren nach Anspruch 8 zur Anwendung bei überarbeitbaren oder zu überarbeitenden, gebondeten Wafern (1, 2).

## Claims

1. An apparatus for determining local alignment errors which have occurred due to strain and/or distortion of a first substrate (1) relative to a second substrate (2) when the first substrate (1) is joined to the second substrate (2) with the following features:
- a first strain map of strain values along a first contact surface (1k) of the first substrate (1) and/or a first stress map of stress values along the first contact surface (1k) can be detected by detection means and/or
- a second strain map of strain values along a second contact surface (2k) and/or a second stress map of stress values along the second contact surface (2k) can be detected by the detection means and
- evaluation means for evaluation of the first and/second strain maps and/or of the first and/or second stress maps by which the local alignment errors can be determined.

2. The apparatus as claimed in Claim 1, which is made to consider first position maps of first alignment keys (3.1 to 3.n) and/or second position maps of second alignment keys (4.1 to 4.n), especially in the determination by the evaluation means.

3. A device for determining local alignment errors which have occurred due to strain and/or distortion of a first substrate (1) relative to a second substrate (2) when the first substrate (1) is joined to the second substrate (2) with the following features:
- a first initial strain map of strain values along a first contact surface (1k) of the first substrate (1) and/or a first initial stress map of stress values along the first contact surface (1k) can be detected by initial detection means and/or
- a second initial strain map of strain values along a second contact surface (2k) and/or a second initial stress map of stress values along the second contact surface (2k) can be detected by the initial detection means and
- the apparatus as claimed in Claim 1, the first and/second initial strain maps and/or the first and/or second initial stress maps being able to be considered by the evaluation means in the determination of the local alignment errors.

4. A device for joining a first contact surface (1k) of a first substrate (1) which can be accommodated on a first platform (10) to a second contact surface (2k) of a second substrate (2) which can be accommodated on a second platform (20) with the following features:
- a first position map of first alignment keys (3.1 to 3.n, 50') which are located along the first contact surface (1k) can be detected by position detection means (7, 8),
- a second position map of second alignment keys (4.1 to 4.n, 50) which are located along the second contact surface (2k) can be detected by position detection means (7, 8),
- the apparatus as claimed in Claim 1 or 2 or the device as claimed in Claim 3,
- computation means for determining a first alignment position of the first contact surface (1k) and a second alignment position of the second contact surface (2k) based on the values of the first position map and the values of the second position map
- alignment means for alignment of the first contact surface (1k) into the first alignment position and of the second contact surface (2k) into the second alignment position and
- means for joining of the first and the second substrate (1, 2).

5. The device as claimed in Claim 4, wherein there are detection means for testing of the first and/or second alignment positions during the joining of the substrates (1, 2), especially in-situ.

6. The device as claimed in Claim 5, in which the testing takes place through transparent regions (40) of the first substrate (1) and/or of the second substrate (2).

7. The device as claimed in Claim 5 or 6, wherein there are at least two, preferably four corresponding alignment keys (3.1 to 3.4, 4.1 to 4.4) at a time for testing.

8. A method for determining local alignment errors which have occurred due to strain and/or distortion of a first substrate (1) relative to a second substrate (2) when the first substrate (1) is joined to the second substrate (2) with the following steps, in particular the following progression:
- detecting a first strain map of strain values along a first contact surface (1k) of the first substrate (1) and/or a first stress map of stress values along the first contact surface (1k) by detection means and/or
- detecting a second strain map of strain values along a second contact surface (2k) and/or a second stress map of stress values along the second contact surface (2k) by the detection means and
- evaluating the first and/second strain maps and/or first and/or second stress maps by evaluation means and determination of the local alignment errors.

9. The method as claimed in Claim 8, in the evaluation first position maps of first alignment keys (3.1 to 3.n, 50') and/or second position maps of second alignment keys (4.1 to 4.n, 50), being considered especially in the determination.

10. The method as claimed in Claim 8 or 9, in which there are the further steps:
- detection of a first initial strain map of strain values along the first contact surface (1k) and/or of a first initial stress map of stress values along the first contact surface (1k) by initial detection means before joining and/or
- detection of a second initial strain map of strain values along the second contact surface (2k) and/or of a second initial stress map of stress values along the second contact surface (2k) by the initial detection means before joining and
- consideration of the first and/or second initial strain maps and/or the first and/or second initial stress maps by the evaluation means in the determination of the local alignment errors.

11. The method as claimed in one of Claims 8 to 10, in which there are the following further steps:
- detection of a first position map of first alignment keys (3.1 to 3.n, 50') which are located along the first contact surface (1k) by position detection means (7, 8) before joining, detection of a second position map of second alignment keys (4.1 to 4.n, 50) which are located along the second contact surface (2k) by position detection means (7, 8) before joining,
- determination of a first alignment position of the first contact surface (1k) and of a second alignment position of the second contact surface (2k) based on the values of the first position map and the values of the second position map by computation means,
- alignment of the first contact surface (1k) into the first alignment position and of the second contact surface (2k) into the second alignment position by alignment means and
- joining of the first and the second substrate (1, 2).

12. The method as claimed in one of Claims 8 to 11, in which there is the following further step:
- testing of the first and/or second alignment positions during the joining of the substrates (1, 2), in particular in-situ, by detection means, in particular through transparent regions (40) of the first substrate (1) and/or of the second substrate (2).

13. The use of the apparatus as claimed in Claim 1 or of the device as claimed in Claim 4 for bonded wafers (1, 2) which can be touched up or which are to be touched up.

14. The method as claimed in Claim 8 for use in bonded wafers (1, 2) which can be reworked or which are to be reworked.

## Revendications

1. Dispositif pour déterminer des défauts d'alignement locaux apparus du fait de l'extension et/ou de la distorsion d'un premier substrat (1) par rapport à un deuxième substrat (2) lors de la liaison du premier substrat (1) avec le deuxième substrat (2) avec les caractéristiques suivantes :
- une première carte d'extension de valeurs d'extension le long d'une première surface de contact (1k) du premier substrat (1) et/ou une première carte de tension de valeurs de tension le long de la première surface de contact (1k) est/sont détectable(s) par des moyens de détection et/ou
- une deuxième carte d'extension de valeurs d'extension le long d'une deuxième surface de contact (2k) et/ou une deuxième carte de tension de valeurs de tension le long de la deuxième surface de contact (2k) étant détectable(s) par les moyens de détection et
- des moyens d'évaluation pour évaluer les premières et/ou deuxièmes cartes d'extension et/ou les premières et/ou deuxièmes cartes de tension, grâce auxquels on peut déterminer les défauts d'alignement locaux.

2. Dispositif selon la revendication 1, lequel est réalisé en tenant compte de premières cartes de position de premières clés d'alignement (3.1 à 3.n) et/ou de deuxièmes cartes de position de deuxièmes clés d'alignement (4.1 à 4.n), en particulier lors de la détermination par les moyens d'évaluation.

3. Dispositif pour déterminer des défauts d'alignement locaux apparus du fait de l'extension et/ou de la distorsion d'un premier substrat (1) par rapport à un deuxième substrat (2) lors du collage ou pré-collage du premier substrat (1) avec le deuxième substrat (2) avec les caractéristiques suivantes :
- une première carte d'extension de départ de valeurs d'extension le long d'une première surface de contact (1k) du premier substrat (1) et/ou une première carte de tension de départ de valeurs de tension le long de la première surface de contact (1k) est/sont détectable(s) par des moyens de détection de départ et/ou
- une deuxième carte d'extension de départ de valeurs d'extension le long d'une deuxième surface de contact (2k) et/ou une deuxième carte de tension de départ de valeurs de tension le long de la deuxième surface de contact (2k) étant détectable(s) par les moyens de détection de départ et
- le dispositif selon la revendication 1, les premières et/ou deuxièmes cartes d'extension de départ et/ou les premières et/ou deuxièmes cartes de tension de départ pouvant être prises en compte par les moyens d'évaluation lors de la détermination des défauts d'alignement locaux.

4. Dispositif pour la liaison entre une première surface de contact (1k) d'un premier substrat (1) pouvant être réceptionné sur une première plateforme (10) et une deuxième surface de contact (2k) d'un deuxième substrat (2) pouvant être réceptionné sur une deuxième plateforme (20) avec les caractéristiques suivantes :
- une première carte de position de premières clés d'alignement (3.1 à 3.n ; 50') disposées le long de la première surface de contact (1k) peut être détectée par des moyens de détection de position (7, 8),
- une deuxième carte de position de deuxièmes clés d'alignement (4.1 à 4.n, 50) disposées le long de la deuxième surface de contact (2k) pouvant être détectée par les moyens de détection de position (7, 8),
- le dispositif selon les revendications 1 ou 2 ou le dispositif selon la revendication 3,
- des moyens de calcul pour déterminer une première position d'alignement de la première surface de contact (1k) et une deuxième position d'alignement de la deuxième surface de contact (2k) sur la base des valeurs de la première carte de position et des valeurs de la deuxième carte de position,
- des moyens d'alignement pour l'alignement de la première surface de contact (1k) dans la première position d'alignement et de la deuxième surface de contact (2k) dans la deuxième position d'alignement et
- des moyens pour la liaison entre les premier et deuxième substrats (1, 2).

5. Dispositif selon la revendication 4, **caractérisé en ce que** l'on prévoit des moyens de détection pour vérifier les première et deuxième positions d'alignement pendant la liaison entre les substrats (1, 2), en particulier in-situ.

6. Dispositif selon la revendication 5, avec lequel la vérification s'effectue à travers des zones transparentes (40) du premier substrat (1) et/ou du deuxième substrat (2).

7. Dispositif selon la revendication 5 ou 6, **caractérisé en ce que** pour la vérification, on prévoit au moins deux clés d'alignement, de préférence respectivement quatre clés d'alignement (3.1 à 3.4, 4.1 à 4.4) correspondantes.

8. Procédé pour la détermination de défauts d'alignement locaux apparus du fait de l'extension et/du de la distorsion d'un premier substrat (1) par rapport à un deuxième substrat (2) lors de la liaison du premier substrat (1) avec le deuxième substrat (2) avec les étapes suivantes, en particulier le déroulement suivant :
- détection d'une première carte d'extension de valeurs d'extension le long d'une première surface de contact (1k) du premier substrat (1) et/ou d'une première carte de tension de valeurs de tension le long de la première surface de contact (1k) grâce à des moyens de détection et/ou
- détection d'une deuxième carte d'extension de valeurs d'extension le long d'une deuxième surface de contact (2k) et/ou d'une deuxième carte de tension de valeurs de tension le long de la deuxième surface de contact (2k) grâce aux moyens de détection et
- évaluation des premières et/ou deuxièmes cartes d'extension et/ou des premières et/ou deuxièmes cartes de tension grâce à des moyens d'évaluation et détermination des défauts d'alignement locaux.

9. Procédé selon la revendication 8, moyennant quoi lors de l'évaluation, on tient compte de premières cartes de position de premières clés d'alignement (3.1 à 3.n, 50') et/ou de deuxièmes cartes de position de deuxièmes clés d'alignement (4.1 à 4.n, 50), en particulier lors de la détermination.

10. Procédé selon les revendications 8 ou 9, avec lequel on prévoit les autres étapes suivantes :
- détection d'une première carte d'extension de départ de valeurs d'extension le long de la première surface de contact (1k) et/ou d'une première carte de tension de départ de valeurs de tension le long de la première surface de contact (1k) grâce à des moyens de détection de départ avant la liaison et/ou
- détection d'une deuxième carte d'extension de départ de valeurs d'extension le long de la deuxième surface de contact (2k) et/ou d'une deuxième carte de tension de départ de valeurs de tension le long de la deuxième surface de contact (2k) grâce aux moyens de détection de départ avant la liaison et
- prise en compte des premières et/ou deuxièmes cartes d'extension de départ et/ou des premières et/ou deuxièmes cartes de tension de départ grâce aux moyens d'évaluation lors de la détermination des défauts d'alignement locaux.

11. Procédé selon l'une des revendications 8 à 10, avec lequel on prévoit les autres étapes suivantes du procédé :
- détection d'une première carte de position de premières clés d'alignement (3.1 à 3.n, 50') disposées le long de la première surface de contact (1k) grâce à des moyens de détection de position (7, 8) avant la liaison,
- détection d'une deuxième carte de position de deuxièmes clés d'alignement (4.1 à 4.n, 50) disposées le long de la deuxième surface de contact (2k) grâce aux moyens de détection de position (7, 8) avant la liaison
- détermination d'une première position d'alignement de la première surface de contact (1k) et d'une deuxième position d'alignement de la deuxième surface de contact (2k) sur la base des valeurs de la première carte de position et des valeurs de la deuxième carte de position grâce à des moyens de calcul,
- alignement de la première surface de contact (1k) dans la première position d'alignement et de la deuxième surface de contact (2k) dans la deuxième position d'alignement grâce à des moyens d'alignement et
- liaison entre les premier et deuxième substrats (1, 2).

12. Procédé selon l'une des revendications 8 à 11, avec lequel on prévoit l'autre étape suivante :
- vérification des première et/ou deuxième positions d'alignement pendant la liaison des substrats (1, 2), en particulier in-situ, grâce à des moyens de détection, en particulier à travers des zones transparentes (40) du premier substrat (1) et/ou du deuxième substrat (2).

13. Utilisation du dispositif selon la revendication 1 ou du dispositif selon la revendication 4 pour des tranches (1, 2) collées pouvant être retravaillées ou à retravailler.

14. Procédé selon la revendication 8 pour l'utilisation en cas de tranches collées (1, 2) pouvant être retravaillées ou à retravailler.
